(19) Europäisches Patentamt
European Patent Office
Office européen des brevets

(11) **EP 0 561 486 B1**

(12) **EUROPEAN PATENT SPECIFICATION**

(45) Date of publication and mention
of the grant of the patent:
**22.10.1997 Bulletin 1997/43**

(51) Int Cl.$^6$: **G03F 7/20**

(21) Application number: **93300362.6**

(22) Date of filing: **20.01.1993**

(54) **Substrate tilt-type exposure apparatus**

Belichtungsgerät mit kippbarem Substrat

Appareil pour l'exposition de type à substrat inclinable

(84) Designated Contracting States:
**DE FR GB IT**

(30) Priority: **19.03.1992 JP 62971/92**

(43) Date of publication of application:
**22.09.1993 Bulletin 1993/38**

(73) Proprietor: **ORC MANUFACTURING CO., LTD.**
**Chofu-shi, Tokyo (JP)**

(72) Inventor: **Watanuki, Minoru**
**Choufu-shi, Tokyo (JP)**

(74) Representative: **Hillier, Peter et al**
**Reginald W. Barker & Co.,**
**Chancery House,**
**53-64, Chancery Lane**
**London, WC2A 1QU (GB)**

(56) References cited:
DE-A- 4 022 165          US-A- 4 973 850
US-A- 5 037 722

• **DATABASE WPIL Section EI, Week 8537,**
**September 1985 Derwent Publications Ltd.,**
**London, GB; Class V04, AN 85-229212 & SU-A-1**
**144 083 (DYATLENKO)**

**Description**

The present invention relates to an exposure apparatus adapted to photolithographically create an image on the surface of a substrate having holes extending through it and, more particularly, to an exposure apparatus which exposes such a substrate while tilting it to induce adequate photochemical reaction in photoresist electrodeposited on the surface of the substrate and on the inner wall surfaces of the holes, thereby creating an image.

BACKGROUND OF THE INVENTION

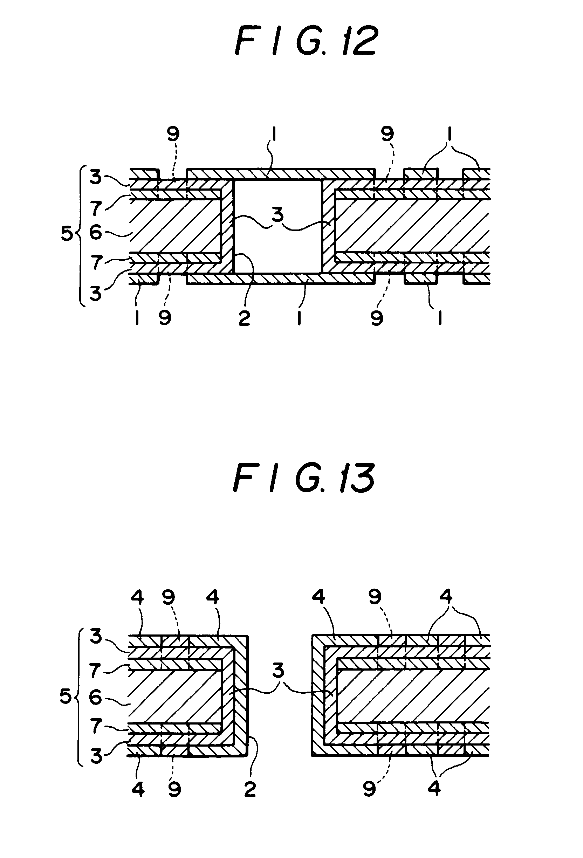

The prior art image formation process involves photolitho-graphically forming patterns on both surfaces of a substrate for a printed-wiring board having holes extending through it and electrically connecting together the formed patterns via a copper- plated layers formed on the inner wall surfaces of the holes. In this process, in order to prevent the copper-plated layers from being damaged by the etching, either tenting or soldering techniques are used. Where the tenting techniques are employed, the surface of a substrate is covered with a dry film. The opening of each hole 2 is closed by a thin film 1 hardened by exposure, as shown in Fig. 12. Where the soldering techniques are adopted, after exposure and development, the exposed surface of copper plating 3 is plated with solder 4, as shown in Fig. 13. In this way, cumbersome pretreatment has been needed for the etching. In these figures, indicated by 5 is the substrate or copper-bonded laminate. Also shown are an insulator 6 and copper foil 7. The portions 9 partitioned by the broken lines are etched away.

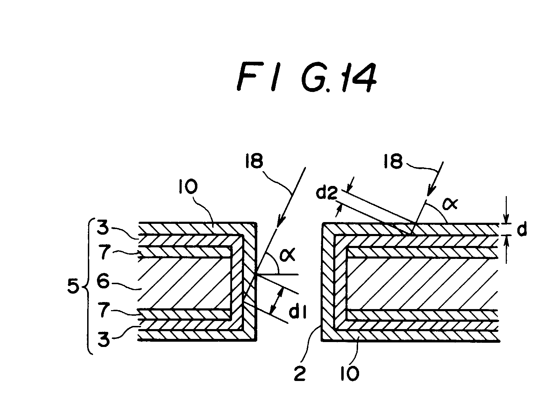

In an attempt to solve the foregoing problems, the present applicant has proposed an improved exposure apparatus as described in Japanese Patent Laid-Open No. 254455/1990. Specifically, as shown in Fig. 14, a photoresist 10 that is a photosensitive resin capable of electroplating is electrodeposited on the surface of a substrate 5 and on the inner wall surface of each hole 2 extending through the substrate. The photoresist inside the holes 2 is hardened with ultraviolet rays which are used for creating an image, thus protecting a copper-plated layer 3.

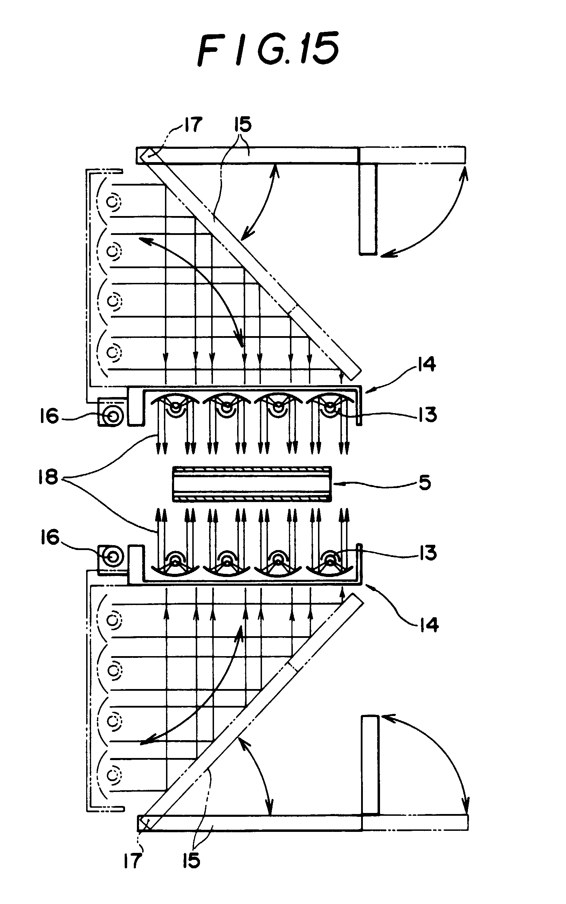

As shown in Fig. 15, this apparatus comprises light sources 14 and foldable, flat reflecting mirrors 15. Each light source 14 consists of a plurality of ultraviolet lamps 13. The light sources 14 and the mirrors 15 are mounted so as to be rotatable about axes 16 parallel to the substrate 5. When the light sources 14 are placed close to the substrate 5 and horizontally as indicated by the solid lines, ultraviolet rays are emitted to harden the photoresist inside the holes. Then, the light sources 14 are brought into their raised positions at which they are perpendicular to the substrate 5 as indicated by the phantom lines. Under this condition, ultraviolet rays are illuminated via the flat reflecting mirrors 15 to harden the photoresist on the surface of the substrate.

This apparatus dispenses with the above-described cumbersome pretreatment, since the copper-plated layer 3 inside each hole is protected by the hardened photoresist. Also, the light sources 14 are used for two purposes, i.e., the formation of a pattern and the protection of the holes. Hence, exposure can be effected by the use of a single apparatus.

However, the above-described exposure apparatus has still room for improvement as described now. When the inside of each hole is photolithographically exposed, ultraviolet rays 18 enter the holes at right or nearly right angles to the substrate 5 and, therefore, the intensity of the ultraviolet rays used for exposing the inside of the holes is much larger than the intensity of the ultraviolet rays used for exposing the surface of the substrate as described later.

Accordingly, when the inside of each hole is exposed, a mask (not shown) is placed on the photoresist 10 on the surface of the substrate. When the surface of the substrate is subsequently exposed, an exposure operation must be carried out via a lithographic film after removing the mask. Therefore, smooth progress of the exposure operation is impeded.

The relation between the incident angle of the ultraviolet rays and the intensity of ultraviolet rays that harden the photoresist is now discussed. When the ultraviolet rays 18 enter the substrate 5 having the photoresist 10 of a thickness d at an incident angle of $\alpha$ as shown in Fig. 14, the amount of exposing light sufficient to harden the photoresist 10 of the thickness $d_1$ inside each hole is given by equation (1).

$$d_1 = d / \cos \alpha \qquad (1)$$

The amount of exposing light needed to harden the photoresist 10 of the thickness $d_2$ on the surface of the substrate is given by equation (2).

$$d_2 = d / \sin \alpha \qquad (2)$$

Hence, the ratio of the former amount to the latter amount is $d_1/d_2 = \tan \alpha$. When $\alpha = 85$ degrees, the ratio (tan $\alpha$) is $d_1/d_2 \fallingdotseq 11$. Thus, it can be seen that intense ultraviolet radiation is required to expose the inside of each hole. On the other hand, when $\alpha = 70$ degrees, $d_1/d_2 \fallingdotseq 2.74$. It can be seen, therefore, that the value of $d_1/d_2$ is affected greatly by the tilt angle.

Another problem with the apparatus shown in Fig. 15 is that a plurality of ultraviolet lamps are needed to permit the ultraviolet rays 18 to enter the holes located near the periphery of the substrate. This increases the amount of electric power consumed by the light sources.

To solve the foregoing problems, an exposure apparatus as shown in figure 19 has been earnestly investigated. This apparatus has an upper and lower ultraviolet light sources. Each light source consists of a single discharge lamp 13 and a reflecting mirror 20. A light-transmitting body 22 made of ground glass is disposed midway between each light source and a substrate 5 in such a way that the upper and lower light transmitting bodies are arranged symmetrically. Substantially uniform light 23 which has no directivity and is transmitted through the light transmitting bodies 22 is scattered. The scattered light 23 is directed to the whole of the surface of the substrate 5 to harden the photoresist electrodeposited on the surface of the substrate 5 and inside each hole at the same time.

A tilt type exposure apparatus is described in SU1144083 having an exposure chamber and a table for the PCB with a drive system. The drive takes the form of a shaft and the table is capable of reciprocating motion. The angle of inclination of the table relative to a UV source can be varied.

US patent No. 5147760, acknowledges a prior art exposure apparatus and having two units disposed above and below a PCB substrate, each unit having a lamp, a reflector mirror, and a slit. Ultraviolet light is emitted which diverges at an angle with respect to the central optical axis of the lamp.

The present invention provides a substrate tilt-type exposure apparatus for projecting ultraviolet rays to a substrate via a lithographic film to induce photochemical reaction in photoresist electrodeposited on a surface of the substrate and on an inner wall of holes extending through the substrate, thereby forming an image on the surface of the substrate, said substrate comprising opposed surfaces wherein holes extending through the substrate extend from one of said opposed surfaces to the other of said opposed surfaces, said exposure apparatus comprising a housing for enclosing an exposure chamber and is characterised by a pair of ultraviolet light sources to emit the ultraviolet rays, said ultraviolet light sources having reflecting mirrors of elliptical cross section for gathering reflected light rays,

a plurality of parabolic mirrors reflecting said rays to create collimated rays, and to direct said collimated rays toward said opposed surfaces,
intermediate mirrors and fly eye lenses interposed between said pair of ultraviolet light sources and said plurality of parabolic mirrors for guiding and homogenising said ultraviolet rays, said substrate being positioned between said two opposed parabolic mirrors a vacuum frame for supporting the substrate during exposure,
a posture change device for tilting the vacuum frame at a plurality of angles to change posture of said substrate with respect to said ultraviolet rays.

When ultraviolet rays are emitted vertically while the vacuum frame is tilted by a given angle from the horizontal plane, the rays can be made to enter the substrate at a given tilt angle. Therefore, appropriate photochemical reaction can be caused in the electrodeposited photoresist on the surface of the substrate and in the holes.

(2) When the vacuum frame is transported horizontally while swinging right and left, ultraviolet rays are emitted at the instant when the substrate is inclined right or left at a given tilt angle. Therefore, the rays can be made to enter the substrate at a given angle to the substrate. In consequence, photochemical reaction can be caused in the electrodeposited photoresist on the surface of the substrate and in the holes.

(3) The advantages (1) and (2) described above make it unnecessary to make pretreatment for etching which would have been needed heretofore or to place and remove a mask. Hence, the efficiency of the exposure operation can be improved.

Other objects and features of the invention will appear in the course of the description thereof which follows.

BRIEF DESCRIPTION OF THE DRAWINGS

Fig. 1 is a side elevation in cross section of an exposure apparatus according to the present invention;
Fig. 2 is a fragmentary cross section taken along line II-II of Fig. 1;
Fig. 3 is a partially cutaway plan view of the vacuum frame and the posture change device shown in Fig. 1;
Fig. 4 is an enlarged end view of the substrate shown in Fig. 1, for showing the condition in which ultraviolet rays illuminate holes extending through the substrate;
Fig. 5 is an exploded perspective view of the moving mechanism of the exposure apparatus shown in Fig. 1;
Fig. 6 is a perspective view of the support frame shown in Fig. 1;
Fig. 7 is a view similar to Fig. 6, but showing a modification of the support frame;
Fig. 8 is a side elevation of main portions of another exposure apparatus according to the invention;
Fig. 9 is a cross-sectional view taken along line IIIV-IIIV of Fig. 8;
Fig. 10 is a perspective view of a moving device included in the apparatus shown in Fig. 8;
Fig. 11 is a fragmentary cross section of the moving device shown in Fig. 10, for showing the inner mechanism;
Fig. 12 is a side elevation in cross section, illustrating a conventional method of protecting a copper-plated layer on the inner wall surface of each hole extending through a substrate;
Fig. 13 is a side elevation in cross section, illustrating another conventional method of protecting a copper-plated layer on the inner wall surface of each hole extending through a substrate; Fig. 14 is a side elevation in cross section, illustrating a further conventional method of protecting a copper-plated layer on the inner wall surface of each hole extending through a substrate;

Fig. 15 is a side elevation in cross section of a conventional exposure apparatus, for illustrating the operation; and

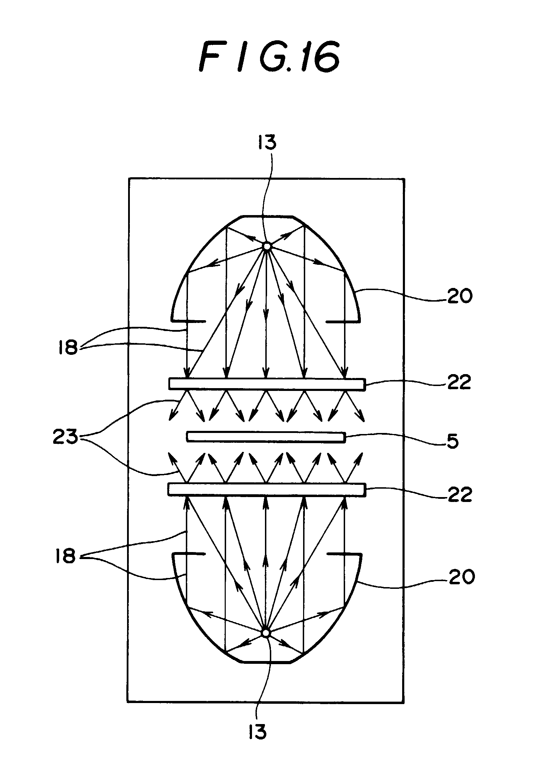

Fig. 16 is a side elevation in cross section of another conventional exposure apparatus, for illustrating the operation.

DETAILED DESCRIPTION OF THE INVENTION

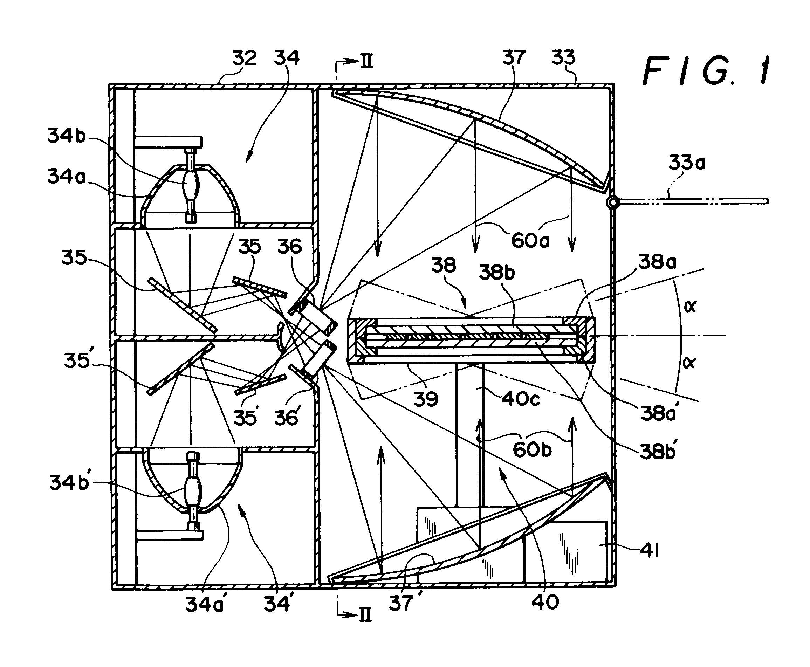

Referring to Figs. 1-4, there is shown an exposure apparatus according to the invention. This apparatus, forming a first embodiment of the invention, comprises ultraviolet light sources 34, 34', a vacuum frame 38, and a posture change device 40.

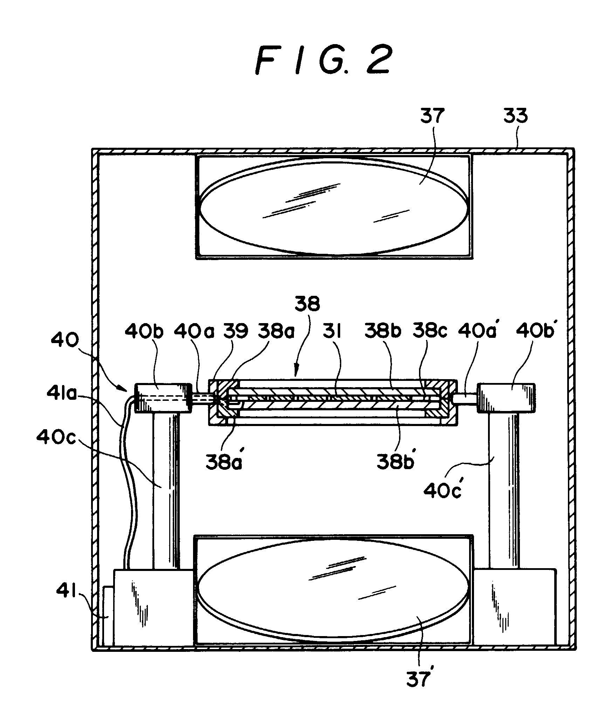

As shown in Figs. 1 and 2, the ultraviolet light source 34 comprises a short arc-shaped discharge lamp 34b, a reflecting mirror 34a of elliptical cross section for gathering reflected light, flat plate type reflecting mirrors 35 for guiding illuminated ultraviolet rays in a given direction, a fly eye lens 36 for homogenizing the intensity of illumination of ultraviolet rays reflected from the reflecting mirrors 35, and a parabolic mirror 37 for reflecting the ultraviolet rays from the lens 36 toward the vertical direction as collimated light rays 60a.

As shown in Figs. 1 and 2, the vacuum frame 38 comprises an upper printing frame 38a, a lower printing frame 38a', an upper transparent plate 38b mounted to the upper printing frame 38a, a lower transparent plate 38b' mounted to the lower printing frame 38b', and a sealing rubber member 38c extending upright from the lower transparent plate 38b' so as to surround a substrate 31. A support frame 39 is mounted to the outer periphery of the lower printing frame 38a' to support the frame 38 in such way that it can be tilted and rotated.

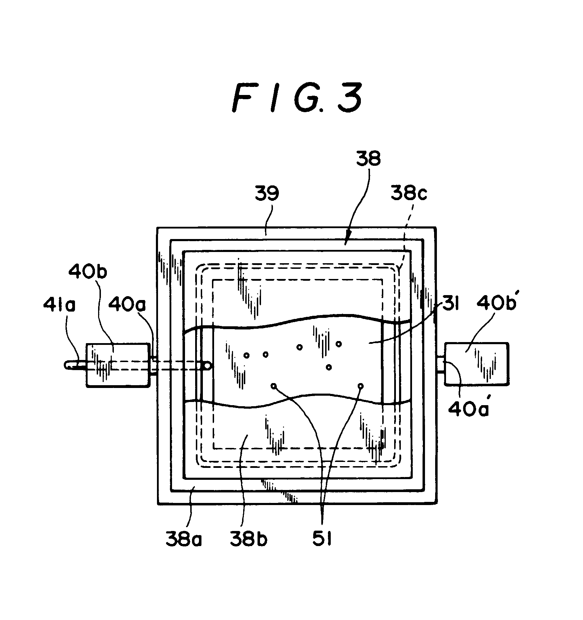

As shown in Figs. 2 and 3, the posture change device 40 comprises support portions 40a, 40a' for supporting the support frame 39 of the vacuum frame 38 so as to be tiltable and rotatable, a driving portion 40b' having a stepping motor that drives one support portion 40a', and a driven portion 40b. The driven portion 40b has a bearing holding the other support portion 40a, and is driven by the driving portion 40b'. The posture change device 40 is further provided with stands 40c and 40c' for holding the driving portions 40b' and 40b at a given height. The tilt angle of the driving portion 40b' is controlled by a control mechanism (not shown).

As shown in Fig. 2, a depressurizing device 41 depressurizes a flat space surrounded by the rubber member 38c of the vacuum frame 38, and the upper and lower transparent plates 38b and 38b'. The depressurizing device 41 has a depressurizing hose 41a which extends through the driven portion 40b of the posture change device 40 and through the center of the support portion 40a and goes downwardly of the lower transparent plate 38b'.

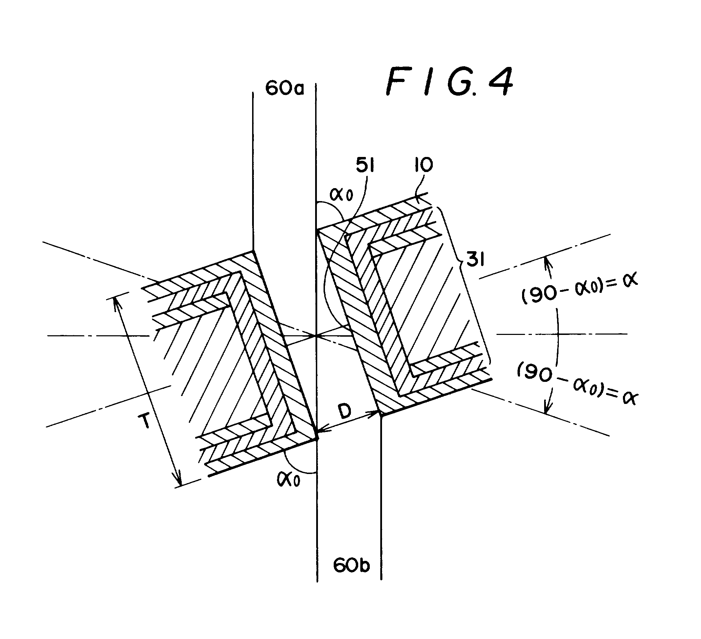

The tilt angle $\alpha$ of the vacuum frame 38 is set by driving the posture change device 40. As shown in Fig. 4, a hole 51 extending through the substrate is assumed to have a depth of T and an inside diameter of D. The tilt angle $\alpha$ is set approximately equal to an angle $\alpha$ which is the difference between 90 degrees and the angle found from the minimum angle $\alpha_0$ that permits the whole inner wall surface of the hole 51 to be illuminated, i.e., arc tan T/D. The set angle is hereinafter referred to as the given tilt angle.

This tilt-type exposure system is operated in the sequence described now. First, a door 33a mounted in an exposure chamber 33 is opened, and the substrate 31 is placed on the vacuum frame 38. At this time, the frame 38 has been already inclined at the given angle. Then, the depressurizing device 41 evacuates the flat space surrounded by the rubber member 38c and the upper and lower transparent plates 38b, 38b' to bring a lithographic film (not shown) into intimate contact with the surface of the substrate 31.

The upper ultraviolet light source 34 and the lower ultraviolet light source 34' emit ultraviolet radiation to the surface of the substrate 31 via the flat reflecting mirrors 35, 35', via the fly eye lenses 36, 36', and via the parabolic mirrors 37, 37'. As a result, collimated ultraviolet rays 60a and 60b impinge on the surface of the substrate 31. The inner wall surface of the hole 51 or the surface of the substrate 31 is illuminated. Those portions of the electrodeposited photoresist which are illuminated are cured. Fig. 4 is an enlarged view illustrating the manner in which the hole 51 is illuminated. The light rays 60a and 60b are incident on the substrate 31 in a parallel relation to each other, the substrate 31 being inclined at the given tilt angle $\alpha$ by the posture change device 40. The rays 60a and 60b impinge on the inner wall surface of the hole 51. Then, the vacuum frame 38 is inclined at the given angle $\alpha$ in the opposite direction by the posture change device 40, and ultraviolet rays are illuminated. As a result, the whole inner wall surface of the hole 51 is substantially uniformly and simultaneously illuminated.

As described above, the tilt angle $\alpha$ of the substrate is determined by the thickness T of the substrate 31 and by the inside diameter D of the hole. If the thickness of the substrate 31 is 1.6 mm, and if the inside diameter of the hole 51 is not less than 0.4 mm, then the tilt angle $\alpha_0$ of the substrate 31 is about 84 degrees. The tilt angle is equal to the difference between the horizontal plane, or 90 degrees, and this angle of 74 degrees, i.e., 16 degrees. Consequently, the hole 51 can be exposed well by inclining the substrate 31.

The intensity of ultraviolet radiation received by the photoresist on the surface of the substrate 31 is tan $\alpha$ times as large as the intensity of ultraviolet radiation received by the photoresist inside the hole as already described in connection with Fig. 14. A standard amount of light illuminating electrodeposited photoresist is 150 to 200 mJ. The upper limit of exposing light which does not impede the subsequent steps including a development step is 600 to 700 mJ. Let us now assume that the amount of exposing light inside the hole 51 is 150 mJ and that the amount of exposing light on the surface of the substrate 31 is 600 mJ. Then, $\tan \alpha = 4$. Therefore, in the present embodiment, if the given tilt angle $\alpha$ set by the posture change device 40 is about 16 degrees, i.e., the thickness of the substrate 31 is 1.6 mm, then good results can be obtained for holes whose inside diameters are in excess of 0.4 mm. As described above, with respect to the surface of the substrate 31 and the hole 51 inclined right or left at the given tilt angle by driving the posture change device 40, photochemical reaction can be completed by two shots of exposure. In consequence, the efficiency of the exposure work can be enhanced.

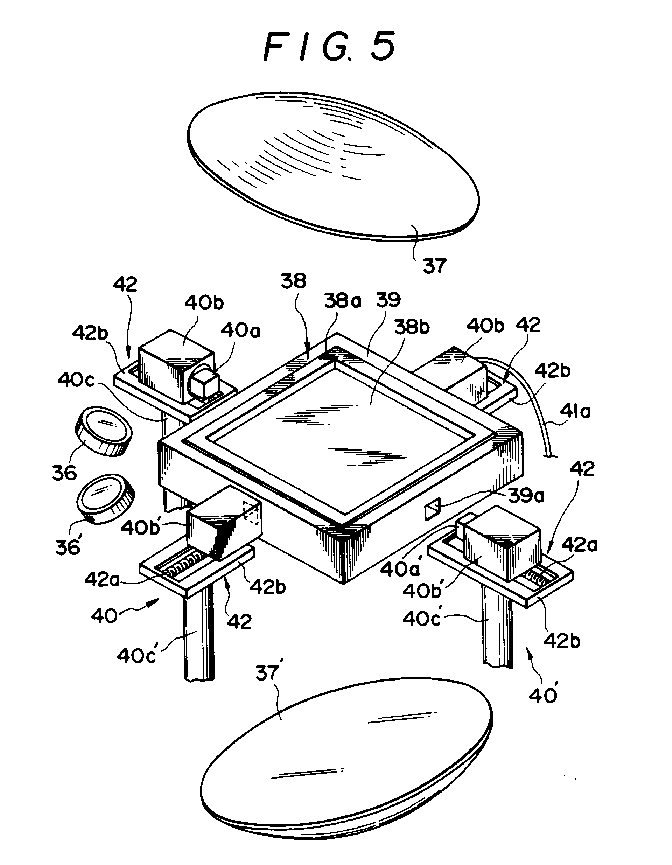

Another exposure apparatus according to the invention is next described by referring to Figs. 5-7. It is to be noted that like components are indicated by like reference numerals in various figures. The substrate tilt-type exposure apparatus, forming a second embodiment of the invention, inclines the vacuum frame 38 right or left at a given tilt angle and exposes the substrate. The exposure apparatus comprises posture change devices 40, 40' located in at least two positions in the frame 38 and having a driving portion 40b' and a driven portion 40b, respectively, and a moving device 42 for moving the driving portion 40b' and the driven portion 40b. As shown in Fig. 5, the posture change device 40 extends perpendicular to the posture change device 40' to support the opposite sides of the frame 38.

The moving device 42 has screw feed mechanisms each including a feed screw 42a and a sliding plate 42b for moving the driving portions 40b' or the driven portions 40b of the posture change devices 40 and 40'. The screw feed mechanisms are controlled by the control mechanism (not shown).

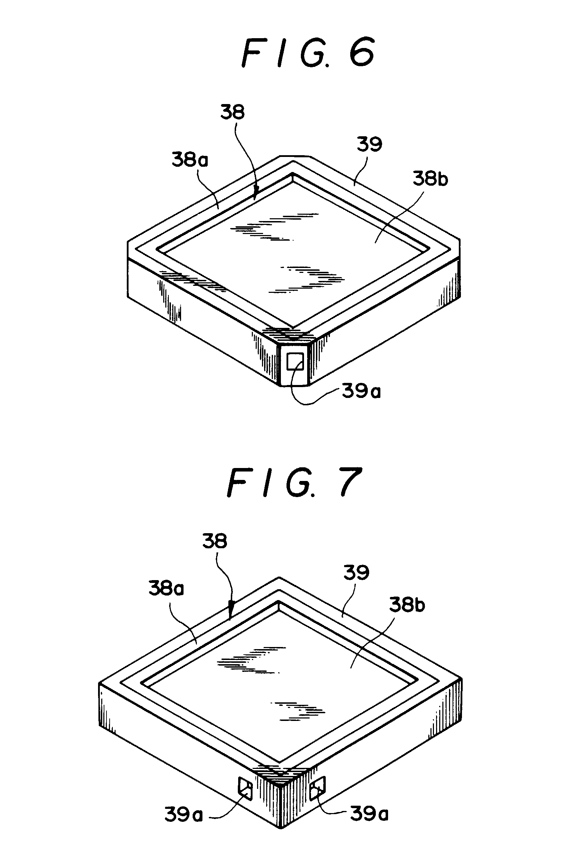

A modification of the support frame 39 supported by the posture change devices 40 and 40' is shown in Fig. 6. Every corner of the square is beveled and provided with a fitting hole 39a. Support portions 40a and 40a' of the posture change devices 40 and 40' can be inserted into these fitting holes 39a. Another modification is shown in Fig. 7. In this way, the support frame 39 may be held at any position by the posture change devices as long as it is located on the outer periphery. Advantageously, the support frame 39 supported by the posture change devices are omitted, and the support portions 40a and 40a' of the posture change devices 40 and 40' are rotatably held at given positions on the lower printing frame 38a' of the vacuum frame 38.

When the posture change devices 40 and 40' are placed in a perpendicular relation to each other and the moving device 42 is operated, the vacuum frame 38 is first tilted left and right by a given angle (see Figs. 1 and 4) by the driven portion 40b. At these positions, the ultraviolet light sources 34 and 34' emit ultraviolet rays. Then, one driving portion 40b' and one driven portion 40b supporting the vacuum frame 38 are moved by the moving device 42. The other driving portion 40b' and the driven portion 40b are moved by the moving device 42 and then the frame 38 is held. The vacuum frame 38 held by the other posture change device 40' is tilted left and right (see Figs. 1 and 4) by the given angle by the posture change device 40' in a direction perpendicular to the direction of tilt caused by the posture change device 40. The ultraviolet light sources 34 and 34' emit ultraviolet rays, thus completing the photochemical reaction.

The aforementioned moving device 42 may be so designed that rails are laid under the posture change devices 40 and 40' and that these devices 40 and 40' can move on these rails.

In the description made above, the ultraviolet light sources 34 and 34' including the reflecting mirror 35 and the fly eye lens 36 are spaced apart vertically from each other. Alternatively, only one of the upper and lower ultraviolet light sources may be mounted. The posture change device may be mounted at one or two locations. During exposure operation, the support frame 39 may be turned over by this posture change device 40.

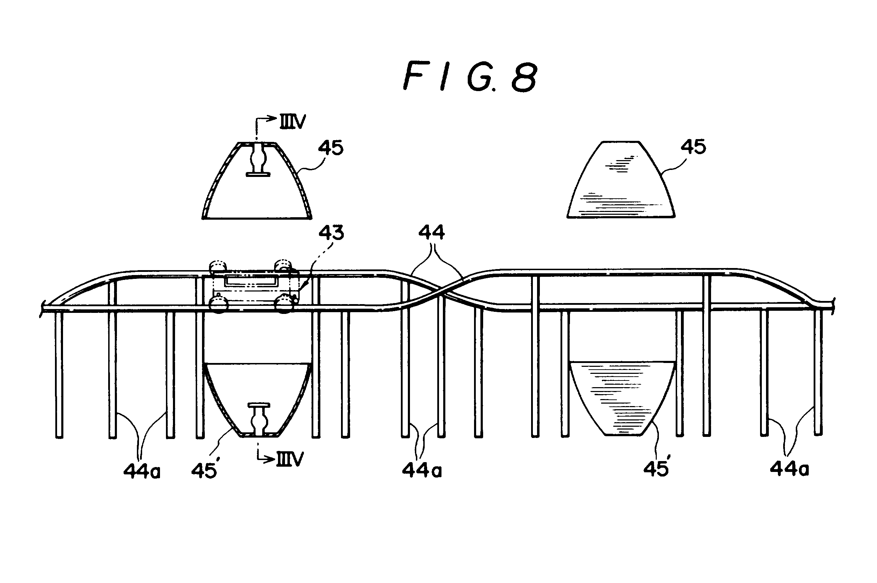

A substrate-tilt type exposure apparatus which moves and exposes a substrate in accordance with the present invention is next described by referring to Figs. 8-11. It is to be noted that like components are indicated by like reference numerals in various figures. As shown in Figs. 8-11, the substrate-tilt type exposure apparatus comprises a vacuum frame 38 attracting a substrate 31 by making use of a vacuum, a conveyor device 43 for transporting the frame 38, rails 44 on which the frame 38 are moved by the conveyor device 43, an ultraviolet light source 45 located above the rails 44, and an ultraviolet light source 45' located below the rails 44.

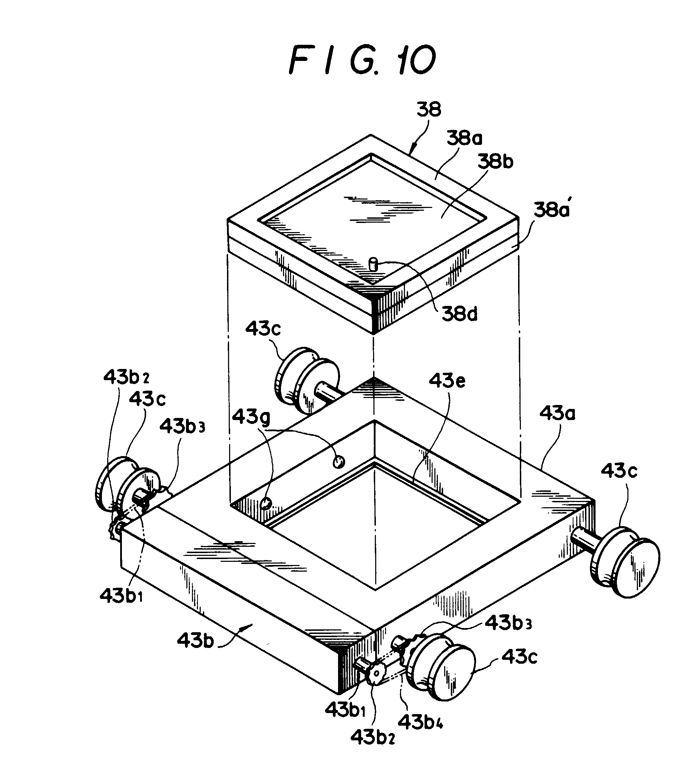

As described already in connection with Fig. 2, the vacuum frame 38 comprises an upper printing frame 38a, a lower printing frame 38a', an upper transparent plate 38b mounted to the upper printing frame 38a, a lower transparent plate 38b' mounted to the lower printing frame 38a', and a sealing rubber member 38c extending upright from the lower transparent plate 38b' so as to surround the substrate 31. To depressurize the space surrounded by the transparent plates 38b, 38b', and the rubber member 38c, the upper transparent plate 38b is provided with a connection port 38d to which a depressurizing hose 41a from the depressurizing device 41 is detachably mounted. This connection port 38d (Fig. 10) is designed so that after the hose 41a is connected and the space is depressurized, the hose is disconnected from the port 38d. In this state, the depressurized condition is maintained.

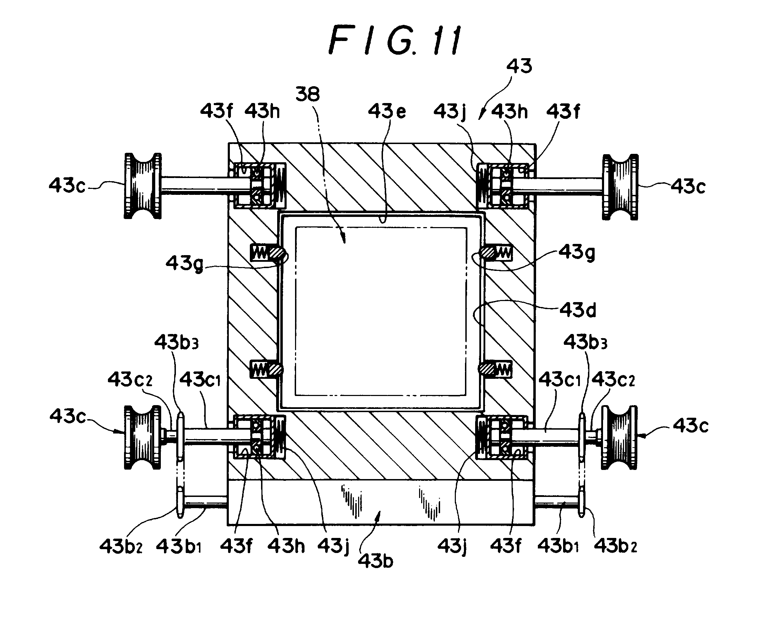

As shown in Figs. 10 and 11, the conveyor device 43 comprises a body 43a which is shaped like a frame and in which the vacuum frame 38 is detachably fitted, a driving device 43b having an electric motor (not shown) mounted at one side of the body 43a, and retractable wheels 43c mounted at the four corners of the body 43a. Shafts $43b_1$ protrude from the driving device 43b. Sprockets $43b_2$ are mounted at the front ends of the shafts $43b_1$, respectively. Sprockets $43b_3$ are mounted to the shafts $43c_1$ of the front wheels 43c, respectively. Chains $43b_4$ are trained around the sprockets $43b_2$ and $43b_3$ and extend between them to transmit power. Stoppers 43e protrude inwardly from the four inner sides 43d of the body 43a at the bottom of the body 43a. Spring-loaded protrusions 43g are formed at appropriate positions on the inner sides 43d.

As shown in Fig. 11, the body 43a is provided with a recess at the base of each wheel $43c_1$ of the body 43a. Each wheel $43c_1$ has a tubular portion 43f, a bearing 43h mounted inside the tubular portion 43f, and a spring 42j mounted between the tubular portion 42f and the recess. The shafts $43c_1$ are designed to be retractable in the axial direction to accommodate variations in the width of rails 44 (described later).

A spline $43c_2$ is mounted on each shaft $43c_1$ on the side of the corresponding wheel 43c. The sprockets $43b_3$ can slide along their respective splines $43c_2$. If the shafts $43c_1$ move in the axial direction according to the width of the rails 44 as described above, power can be transmitted without difficulty.

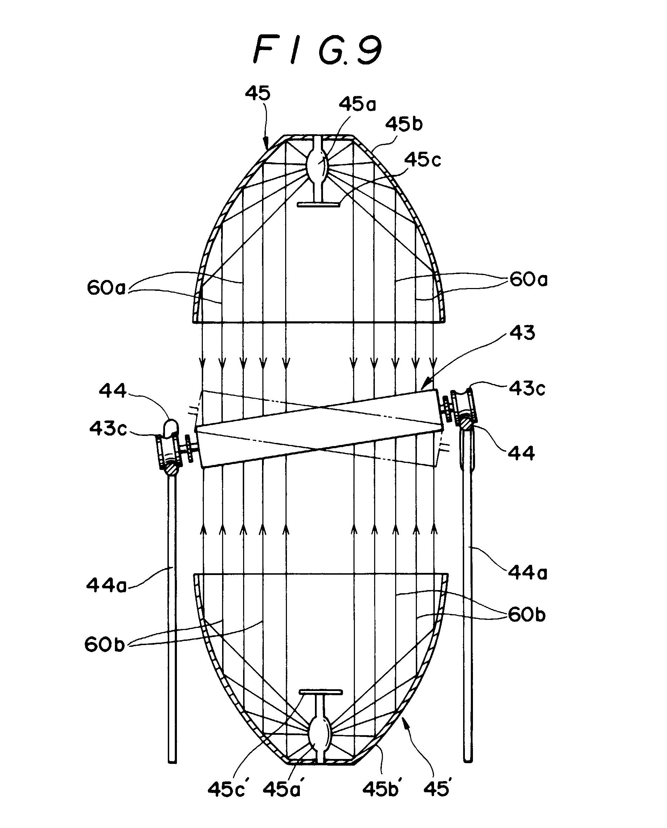

As shown in Figs. 8 and 9, the rails 44 of a circular cross section are two in number and run parallel to each other. The heights of the rails are so varied that they alternate with each other. The rails 44 are held by a plurality of support legs 44a. The heights of the rails determine the given tilt angle of the substrate 31. This given tilt angle is determined by the ratio of the thickness T of the substrate to the inside diameter D of the hole, as described previously in conjunction with Fig. 4.

As shown in Figs. 8 and 9, the upper ultraviolet light source 45 and the lower ultraviolet light source 45' are located at given positions on the rails 44 and arranged vertically symmetrically. The upper ultraviolet light source 45 comprises a short arc-shaped discharge lamp 45a, a reflecting mirror 45b of parabolic cross section for reflecting ultraviolet rays from the discharge lamp 45a as collimated light 60a, a shield plate 45c mounted at one end of the discharge lamp 45a and acting to block direct light. Similarly, the lower ultraviolet light source 45' comprises a short arc-shaped discharge lamp 45a', a reflecting mirror 45b' of parabolic cross section for reflecting ultraviolet rays from the discharge lamp 45a' as collimated light 60b, a shield plate 45c' mounted at one end of the discharge lamp 45a' and acting to block direct light.

In this embodiment, the substrate tilt-type exposure apparatus is advantageously mounted in a housing (not shown) and installed in a clean room. Since heating rays produced from the ultraviolet light sources 45 and 45' heat the inside of the housing, cooling air is supplied from an air intake port formed at a desired position in the housing. The supplied air is circulated. Warmed air is discharged from a ventilation port formed near the top of the housing.

This second embodiment of substrate tilt-type exposure apparatus is operated in the sequence described below. First, the substrate 31 is placed in a desired position on the vacuum frame 38. The depressurizing hose 41a of the depressurizing device 41 is connected with the connection port 38d (Fig. 10) in the frame 38. The space surrounded by the transparent plates 38b, 38b', and the rubber member 38c is depressurized. The hose 41a is disconnected from the connection port 38d. The frame 38 is fitted into the conveyor device 43. The frame 38 is then placed on the stoppers 43e and fixed with the protrusions 43g.

The wheels 43c of the conveyor device 43 are placed on the rails 44. When an instruction button (not shown) is depressed, the conveyor device 43 is moved on the rails 44. When the conveyor device 43 comes close to the ultraviolet light sources 45 and 45', the discharge lamps 45a and 45a' are lit up to thereby emit collimated light rays 60a and 60b. Since the conveyor device 43 moves along the rails 44, the conveyor device is inclined at the given angle. The substrate 31, the collimated light rays 60a, 60b are particularly shown in Fig. 4.

Since the substrate 31 receiving the collimated light rays 60a and 60b are inclined at the given angle, the inside of the hole 51 and the surface of the substrate are exposed (see Fig. 4). The heights of the left and right rails 44 are interchanged, so that the substrate 31 is tilted to the other side and inclined at the given angle. When the substrate approaches the next ultraviolet light source, the discharge lamps 45a and 45a' are lit up, whereby collimated light rays are emitted (Fig. 4). The discharge lamps 45a and 45a' of the ultraviolet light sources 45 and 45' have the shield plates 45c and 45c', respectively. Since the substrate 31 moves along the rails 44 in the axial direction, the accumulated ultraviolet dosage of the substrate 31 is kept constant. This assures exposure of the substrate 31.

The ultraviolet dosage of the photoresist on the surface of the substrate 31 is $\tan \alpha$ times as high as that inside the hole as described already in conjunction with Fig. 14. The standard amount of light impinging on the electrodeposited photoresist is 150 to 200 mJ. The upper limit of overexposure which does not impede the subsequent steps including development is 600 to 700 mJ. If the amount of exposure inside the hole 51 is set to 150 mJ and the amount of exposure on the surface of the substrate 31 is set to 600 mJ, then $\tan \alpha = 4$. In the present embodiment, therefore, the tilt angle $\alpha_0$ is about 74 degrees. The substrate is inclined at 16 degrees (90 degrees - 74 degrees). Where the thickness of the substrate 31 is 1.6 mm, good results arise if the inside diameter is in excess of 0.4 mm.

It is to be understood that the present invention is not limited to the above embodiments and that various changes can be made thereto without departing from the invention as defined in the appended claim. For instance, instead of the conveyor device and the rails in the second embodiment, a feeding roller device disclosed in Japanese patent application Ser. No. 332010/1991 filed by the present applicant and entitled "ultraviolet cleaning mechanism equipped with cleanliness-measuring apparatus" may be employed. The vacuum frame may be transported while inclining a desired portion at a given angle. Also, the vacuum frame may be inclined by the posture change device used in the first embodiment and moved on the laid rails.

As can be seen from the description made thus far, the present invention yields the following advantages.

(1) When ultraviolet rays are emitted vertically while inclining the vacuum frame at a given angle to the horizontal plane, the rays can be made to enter a substrate at a desired tilt angle. Consequently, appropriate photochemical reaction can be induced in the electrodeposited photoresist on the surface of the substrate and inside the hole in the substrate.

(2) The vacuum frame is conveyed horizontally while swinging right and left. When the substrate tilts right or left by a given angle, ultraviolet rays are emitted. Therefore, the rays can be made to enter the substrate at a desired angle. In consequence, appropriate photochemical reaction can be caused in the electrodeposited photoresist on the whole surface of the substrate and in the hole.

(3) As a result of the advantages (1) and (2) described just above, it is not necessary to make pretreatment for etching as in the prior art techniques or to place and remove a mask. This improves the efficiency of the exposure operation.

(4) Where an ultraviolet light source is disposed only on one side, appropriate photochemical reaction can be induced in the electrodeposited photoresist on the surface of the substrate and inside the hole by inverting the frame.

## Claims

1. A substrate tilt-type exposure apparatus for projecting ultraviolet rays to a substrate (31) via a lithographic film to induce photochemical reaction in photoresist electrodeposited on a surface of the substrate (31) and on an inner wall of holes (51) extending through the substrate, thereby forming an image on the surface of the substrate, said substrate comprising opposed surfaces wherein holes extending through the substrate extend from one of said opposed surfaces to the other of said opposed surfaces, said exposure apparatus comprising a housing (33) for enclosing an exposure chamber and is characterised by:

a pair of ultraviolet light sources (34, 34') to emit the ultraviolet rays, said ultraviolet light sources having reflecting mirrors (34a, 34a') of elliptical cross section for gathering reflected light rays, a plurality of parabolic mirrors (37, 37') reflecting said rays to create collimated rays, and to direct said collimated rays toward said opposed surfaces,

intermediate mirrors (35, 35') and fly eye lenses (36, 36') interposed between said pair of ultraviolet light sources (34, 34') and said plurality of parabolic mirrors (37, 37') for guiding and homogenising said ultraviolet rays, said substrate being positioned between said two opposed parabolic mirrors (37, 37'), a vacuum frame (38) for supporting the substrate during exposure,

a posture change device (40) for tilting the vacuum frame at a plurality of angles to change posture of said substrate (31) with respect to said ultraviolet rays.

## Patentansprüche

1. Belichtungsgerät mit kippbarem Substrat zur Projektion ultravioletter Strahlen auf ein Substrat (31) durch einen lithographischen Film, um photochemische Reaktionen in photoresistivem Material, das auf einer Oberfläche des Substrats (31) oder auf einer inneren Wand der durch das Substrat gehenden Öffnungen (51) galvanisch niedergeschlagen ist, hervorzurufen und dabei eine Abbildung auf der Oberfläche des Substrats zu erzeugen, wobei das Substrat gegenüberliegende Oberflächen aufweist und sich Öffnungen durch das Substrat von einer der gegenüberliegenden Oberflächen zu der anderen der gegenüberliegenden Oberflächen erstrekken, wobei das Belichtungsgerät ein Gehäuse (33) umfaßt, das eine Belichtungskammer aufweist und gekennzeichnet ist durch:

ein Paar ultravioletter Lichtquellen (34, 34') zur Abgabe ultravioletter Strahlen, wobei die ultravioletten Lichtquellen Reflektionsspiegel (34a, 34a') elliptischen Querschnitts zum Sammeln reflektierter Lichtstrahlen aufweisen,

eine Mehrzahl von Parabolspiegeln (37, 37'), die die Strahlen reflektieren, um Parallelstrahlen zu erzeugen und um die Parallelstrahlen auf die gegenüberliegenden Oberflächen zu richten,

Zwischenspiegel (35, 35') und Facettenlinsen (36, 36') angeordnet zwischen dem Paar ultravioletter Lichtquellen (34, 34') und der Mehrzahl von Parabolspiegeln (37, 37') zur Führung und Homogenisierung der ultravioletten Strahlen, wobei das Substrat zwischen den zwei gegenüberliegenden Parabolspiegeln (37, 37')
angeordnet ist, einen Vakuumrahmen (38) zur
Unterstützung des Substrats während der Belichtung,

eine Lageänderungseinrichtung (40) zum Kippen des Vakuumrahmens in eine Vielzahl von
Winkeln, um die Lage des Substrats (31) in bezug auf die ultravioletten Strahlen zu ändern.

**Revendications**

1.  Appareil d'exposition de type à inclinaison du substrat pour projeter des rayons ultra-violets sur un
    substrat (31) via un film lithographique pour induire
    une réaction photochimique dans un photorésist
    déposé par galvanoplastie sur une surface d'un
    substrat (31) et sur une paroi intérieure de trous (51)
    s'étendant à travers le substrat, formant ainsi une
    image sur la surface du substrat, ledit substrat comprenant des surfaces opposées dans lesquelles
    des trous s'étendant à travers le substrat s'étendent
    à partir d'une desdites surfaces opposées vers
    l'autre desdites surfaces opposées, ledit appareil
    d'exposition comprenant un boîtier (33) pour envelopper une chambre d'exposition et caractérisé par:

    > deux sources de lumière ultraviolettes (34, 34')
    > pour émettre les rayons ultraviolets, lesdites
    > sources de lumière ultraviolette comportant
    > des miroirs réfléchissants (34a, 34a') de sec-
    > tion transversale elliptique pour rassembler les
    > rayons lumineux réfléchis,
    > une pluralité de miroirs paraboliques (37, 37')
    > réfléchissant lesdits rayons pour créer des
    > rayons collimatés, et pour diriger lesdits rayons
    > collimatés en direction desdites surfaces oppo-
    > sées,
    > des miroirs intermédiaires (35, 35') et des len-
    > tilles de type oeils de mouche (36, 36') interpo-
    > sées entre lesdites deux sources de lumière ul-
    > traviolette (34, 34') et ladite pluralité de miroirs
    > paraboliques (37, 37') pour guider et homogé-
    > néiser lesdits rayons ultraviolets, ledit substrat
    > étant positionné entre lesdits deux miroirs pa-
    > raboliques opposés (37, 37'), un châssis à vide
    > (38) pour supporter le substrat pendant l'expo-
    > sition,
    > un dispositif de changement de position (40)
    > pour incliner le châssis à vide en une pluralité
    > d'angles pour changer la position dudit substrat
    > (31) par rapport auxdits rayons ultraviolets.

FIG. 1

# F I G. 2

# F I G. 3

F I G. 4

# F I G. 5

# F I G. 6

# F I G. 7

F I G. 8

# F I G.9

# F I G. 10

# FIG. 11

EP 0 561 486 B1

# F I G. 12

# F I G. 13

# F I G.14

# F I G.15

# F I G.16